Europäisches Patentamt

European Patent Office

Office européen des brevets

(11) Veröffentlichungsnummer: **0 427 702 A2**

# EUROPÄISCHE PATENTANMELDUNG

(21) Anmeldenummer: 90890297.6

(22) Anmeldetag: 06.11.90

(51) Int. Cl.⁵: **H05K 3/00**

(30) Priorität: 07.11.89 AT 2562/89

(43) Veröffentlichungstag der Anmeldung:
15.05.91 Patentblatt 91/20

(84) Benannte Vertragsstaaten:
**AT DE FR GB IT NL**

(71) Anmelder: **AT & S AUSTRIA TECHNOLOGIE & SYSTEMTECHNIK Gesellschaft m.b.H.**
**Fabrikgasse 13**
**A-8700 Leoben(AT)**

(72) Erfinder: **Vodiunig, Robert, Dipl.-Ing.**
**Stollenweg 19/12**
**A-8700 Leoben(AT)**
Erfinder: **Stahr, Johannes, Dipl.-Ing.**
**Erich-Schmidstrasse 5**
**A-8600 Bruck/Mur(AT)**

(74) Vertreter: **Haffner, Thomas M., Dr.**
**Patentanwaltskanzlei Dipl.-Ing. Adolf Kretschmer Dr. Thomas M. Haffner**
**Schottengasse 3a**
**A-1014 Wien(AT)**

(54) Multilayerleiterplatte sowie Verfahren zu ihrer Herstellung.

(57) Bei einer Multilayerleiterplatte mit flexiblen Bereichen (8), bei welchen starre Plattenbereiche (3) mit einem flexiblen Träger (1) verbunden sind, wird als flexibler Träger (1) eine Polyetherketon- insbesondere Polyetheretherketon-Folie verwendet und es werden die starren Plattenbereiche (3) mit der Folie (1) verklebt.

Bei einem Verfahren zur Herstellung einer derartigen Multilayerleiterplatte wird die Polyetherketon- bzw. Polyether-etherketon-Folie in denjenigen Bereichen (7), welche in der Folge mit den starren Plattenbereichen (3) dauerhaft verbunden werden sollen, zur Erhöhung ihrer Oberflächenspannung oberflächlich durch chemisches Ätzen, Beflammen, Coronaentladung oder Plasmaätzen modifiziert und in der Folge mit dem starren Leiterplattenmaterial (3), insbesondere eines Prepregs (4), verklebt.

FIG. 1

# MULTILAYERLEITERPLATTE SOWIE VERFAHREN ZU IHRER HERSTELLUNG

Die Erfindung bezieht sich auf eine Multilayerleiterplatte mit flexiblen Bereichen, bei welcher starre Plattenbereiche mit einem flexiblen Träger verbunden sind, sowie auf ein Verfahren zur Herstellung einer derartigen Leiterplatte.

Leiterplatten mit starren und flexiblen Bereichen können für unterschiedliche Zwecke eingesetzt werden. Ein wesentlicher Vorteil derartiger Leiterplatten besteht darin, daß Verbindungen zwischen zwei gedruckten Schaltungen über flexible Bereiche unmittelbar ohne aufwendige Lötarbeiten im Zuge der Herstellung der gedruckten Schaltungen hergestellt werden können, so daß eine überaus raumsparende Konstruktion ermöglicht wird. Mit der verminderung des herstellungstechnischen Aufwandes durch Wegfall zusätzlicher Assemblierungs- und Lötarbeiten ist gleichzeitig der Vorteil verbunden, daß die dynamische Belastbarkeit der Einheit erhöht und die Bruchgefahr der Leitungsverbindungen verringert wird und derart die Zuverlässigkeit erhöht wird. Insbesondere in Anwendungsgebieten mit hohen dynamischen Belastungen, wie beispielsweise im Kraftfahrzeugbau, bei Flugzeugelektronik od. dgl. können derartige starr-flexible Leiterplatten eine wesentliche Steigerung der Zuverlässigkeit mit sich bringen. Unter starr-flexiblen Leiterplatten werden im allgemeinen hiebei solche Aufbauten verstanden, bei denen starre Bereiche, welche wie üblich aus Epoxidharz-Glasgewebe bestehen können, mit flexiblen Bereichen, wie beispielsweise Polyesterfolien, Epoxidglasharzgeweben oder Polyimidfolien in einer Verfahrensweise, welche als Multilayertechnologie bezeichnet wird, miteinander verbunden werden. Starr-flexible Leiterplatten sind beispielsweise in der DE-PS 31 19 884 beschrieben. Gemäß dem dieser DE-PS entnehmbaren Herstellungsverfahren ist es erforderlich, speziell konfektionierte und auf die jeweiligen Bereiche abgestimmt zugeschnittene Verbindungsfolien sowie Trennfolien einzusetzen, wobei die Trenn folien in denjenigen Bereichen angeordnet werden, in welchen in der Folge eine Verbindung der starren Plattenteile mit flexiblen Trägern verhindert werden soll. Bedingt durch den Aufwand für das Konfektionieren, Zuschneiden, Ausstanzen, Ausfräsen od. dgl. der Verbindungs- bwz. Klebefolien und das paßgenaue Ausrichten der Trennfolien ergibt sich eine relativ aufwendige Konfektionierung der Multilayerleiterplatte mit flexiblen Bereichen. Als Trennmedium wird in der DE-PS 31 19 884 Polytetrafluorethylen, beispielsweise in Form einer Beschichtung des starren Materials an den entsprechenden Teilen der Oberfläche genannt. Auch Bleche, insbesondere Messingblech, wurden bereits als besonders geeignetes Trennnedium vorgeschlagen.

Eine zusammenfassende Wiedergabe der als Multilayertechnologie bezeichneten Verfahrensweise für die Herstellung von starr- flexiblen Leiterplatten ist in I.A. Scarlett "The Multilayer Printed Circuit Board Handbook", Seite 450-477, 1985, enthalten, wobei neben der Verklebung der flexiblen Bereiche mittels vorkonfektionierter Klebefolien, wobei ausgestanzte oder ausgefräste Bereiche mit entsprechend zugeschnittenen Trennfolien, wie z.B. Polytetraflourethylen gleicher Dicke, ausgefüllt werden, auch Prepregs auf Epoxidharzbasis, insbesondere in low-flow-Ausführung, für die Verbindung unterschiedlicher Layer des Multilayeraufbaus bekannt sind. Aufgrund des bei Prepregs auftretenden Harzflusses kann es aber bei der Verarbeitung durch unkontrolliertes Fließen des Klebers zu unexakten Konturen der flexiblen bzw. starren Bereiche kommen.

In der EP-B1-0 126 856 wird als Alternative zu Klebefolien ein Aufbringen eines unter Hitze aushärtbaren Klebers im Siebdruckverfahren beschrieben. Auch dieses verfahren beseitigt nicht die prinzipiellen Probleme beim Verpressen von starren und flexiblen gedruckten Schaltungen. Auch in der DE-PS 35 15 549 wird die Herstellung einer starr-flexiblen Leiterplatte beschrieben, die wiederum nicht ohne entsprechend konfektionierte Klebefolien auskommt. Die DE-OS 36 24 719 beschreibt ein Vorlaminat für die Herstellung von starr-flexiblen Leiterplatten, das preisgünstiger sein soll als eine großflächige Verwendung von flexiblen Folien, ohne jedoch die Nachteile bei der Herstellung von starr-flexiblen Leiterplatten zu beseitigen. Aus der genannten DE-OS 36 24 719 ist bereits die Verwendung von Polyesterschichten bzw. Polyimidschichten bekannt, wobei Polyimide aufgrund ihrer überragenden thermischen Eigenschaften bei der Herstellung von starr-flexiblen Leiterplatten besonders vorteilhaft erscheinen. Reine Polyimide sind aber relativ teuer und sind hygroskopisch. Für die Verarbeitung sind spezielle Kleber zumeist auf Cyan-Acrylatbasis erforderlich, wodurch ein ungünstiges Brandverhalten des Verbundes entsteht.

Die Erfindung zielt nun darauf ab, eine Multilayerleiterplatte der eingangs genannnten Art zu schaffen, welche unter Verwendung eines flexiblen Trägers einfacher hergestellt werden kann und unmittelbar ohne aufwendige Nachbearbeitungen eine exakte Kontur der starren Bereiche erzielen läßt. Weiters zielt die Erfindung darauf ab, eine Mulitlayerleiterplatte der eingangs genannten Art zu schaffen, bei welcher in der Handhabung problematische Kleber vermieden werden. Zur Lösung dieser Aufgabe besteht die erfindungsgemäße Mulitlayerleiterplatte im wesentliche darin, das als flexibler Träger eine Polyetherketon-, insbesondere Polyetheretherketon-Folie verwendet wird und daß die starren Plattenbereiche mit der Folie verklebt sind. Mit der Verwendung von Polyetherketon- bzw. Polyetheretherketon-Folien wird an Stelle des überaus teuren Polyimids ein polymeres Material eingesetzt, welches sich durch hohe thermische Beständigkeit, hohe Chemikalienbeständigkeit gegenüber Säuren und Laugen sowie hohe mechanische Festigkeit und Dimensionsstabilität auszeichnet. Das verwendete Polyetherketon bzw. Polyetheretherketon weist darüber hinaus auch eine hohe Haftfestigkeit von Kupferfolien auf und eine für ein erfindungsgemäßes Verfahren günstige, niedrige Oberflächenspannung von deutlich unter 40mN/m, wobei dieser Wert für die Wasserbenetzbarkeit charakteristisch ist. Eben dieser Oberflächenspannung der verwendeten Folie kommt insoferne besondere Bedeutung zu, da ein Material mit niedriger Oberflächenspannung, welches zu geringer Wasserbenetzbarkeit führt, in der Regel nur schwer klebbar ist.

Um die Probleme mit der Klebbarkeit des erfindungsgemäß verwendeten Polyetherketons bzw. Polyetheretherketons sicher zu beherrschen, besteht das erfindungsgemäße Verfahren zur Herstellung einer Multilayerleiterplatte der obigen Art im wesentlichen darin, das die Polyetherketon- bzw. Polyetheretherketon-Folie in denjenigen Bereichen, welche in der Folge mit den starren Plattenbereichen dauerhaft verbunden werden sollen, zur Erhöhung ihrer Oberflächenspannung oberflächlich durch chemisches Ätzen, Beflammen, Coronaentladung oder Plasmaätzen modifiziert wird und in der Folge mit dem starren Leiterplattenmaterial, insbesondere unter Zwischenschaltung eines Prepreg, verklebt wird. Dadurch, das die Polyetherketon- bzw. Polyetheretherketon-Folie in denjenigen Bereichen, welche in der Folge mit den starren Plattenbereichen dauerhaft verbunden werden sollen, zur Erhöhung ihrer Oberflächenspannung modifiziert werden, wird die Klebbarkeit wesentlich verbessert, und es verbleiben diejenigen Bereiche, welche in der Folge die Flexibilität sicherstellen sollen und in der Regel frei den atmosphärischen Bedingung ausgesetzt werden, in einer Oberflächenstruktur, welche eine niedrige Oberflächenspannung und damit geringe Wasserbenetzbarkeit ergibt. Die Modifikation der Oberfläche zur Verbesserung der Verklebungseigenschaften kann hiebei prinzipiell durch chemische Ätzverfahren, Beflammen mit einer Gasflamme oder ähnliche Verfahren und insbesondere durch Coronaentladung bzw. Plasmaätzen erzielt werden. Auf diese Weise können aufwendige und schwer zu handhabende Spezialkleber vermieden werden und die Benetzbarkeit wird sogar so weit verbessert, das ein Verkleben von auf diese Weise vorbehandelten Teilbereichen der Polyetherketon- bzw. Polyetheretherketon-Folien unter Zwischenschaltung eines Prepregs gelingt.

Die erfindungsgemäße Verfahrensführung unter Verwendung von Polyetherketonfolien hat hiebei den wesentlichen Vorteil, das die Verwendung von Klebebändern, Metallfolien bzw. Trennfolien in den Bereichen, in welchen eine Verbindung mit starren Plattenbereichen nicht erwünscht ist, entfallen kann, da die Haftfestigkeit zwischen nicht behandelten Oberflächenteilen von Polyetherketonfolien und Prepregs so gering ist, daß eine leichte Scherbeanspruchung genügt, um die Trennung wiederum zu bewirken. Umgekehrt erlaubt es die erfindungsgemäße Modifizierung der Oberflächenbereiche, in welchen die dauerhafte Verbindung gewünscht wird, in einfacher Weise diejenigen Bereiche, welche in der Folge nicht mit den weiteren Layers verbunden werden, zu schützen, wobei auch hier auf vergleichsweise umständlich zu handhabende Klebebänder, Metallfolien od. dgl. verzichtet werden kann. Die Beschränkung der Behandlung zum Modifizieren der Oberflächenteile auf die später zu verklebenden oder dauerhaft zu verbindenden Oberflächenteile kann in besonders einfacher Weise so erfolgen, das die zu modifizierende Fläche der Polyetherketon-, insbesondere der Polyetheretherketon-Folie vor der Oberflächenbehandlung mit einem Photoresist beschichtet und zur Freilegung der zu modifizierenden Oberflächenbereiche photolitographisch strukturiert wird, wodurch eine vergleichsweise einfache Verfahrensweise geschaffen wird, welche darüber hinaus zur Ausbildung von scharfen Trennlinien zwischen klebenden und nicht klebenden Bereichen führt, welche eine spätere Nachbearbeitung nach dem Trennen von Prepreg und Polyetherketon-Folien an den gewünschten Stellen nicht mehr notwendig macht.

Nach dem erfindungsgemäßen Verfahren hergestellte, starrflexible Leiterplatten können daher nicht nur ohne die bisher notwendigen teuren, konfektionierten Klebefolien, Zwischenlagen und Trennfolien hergestellt werden, sondern führen unmittelbar, bei vereinfachter Bearbeitung, zu Endprodukten, welche eine Nachbehandlung nicht erforderlich machen. Insbesondere führt die Vorbehandlung der zu verklebenden Oberflächen dazu, daß auch Standardmaterialien in der Leiterplattentechnologie, beispielsweise FR 4, mit entsprechend kompatiblen Klebern, insbesondere aber Pregpregs, eingesetzt werden können und dennoch eine sichere Verbindung zwischen der flexiblen Folie und dem Leiterplattenmaterial erzielt wird.

Der flexible Träger wird erfindungsgemäß bevorzugt mit integrierten und/oder auf einer Fläche strukturierten Leiterbahnen eingesetzt, wobei die von Leiterbahnen freie Seite zur Erhöhung der Oberflächenspannung modifiziert wird. Eine Ausbil

dung mit integrierten Leiterbahnen ist besonders einfach dadurch erzielbar, daß als flexibler Träger für die starren Plattenteile ein zweilagiger Verbund aus Polyetherketon-Folien mit innenliegenden Leiterbahnen eingesetzt wird.

Die chemische bzw. physikalische Aktivierung der Oberflächen bereiche, über welche eine dauerhafte Verbindung mit den starren Plattenteilen erfolgen soll, soll im Rahmen des erfindungsgemäßen Verfahrens so durchgeführt werden, daß die Oberfläche der mit den starren Plattenbereichen zu verbindenden Teilbereiche des flexiblen Trägers zur Ausbildung einer Oberflächenspannung von größer als 50mN/m, vorzugsweise größer als 70mN/m modifziert wird, wobei sich für ein derartiges Anheben der Oberflächenspannung als ideal Plasmaätzen oder Coronaentladungen erwiesen haben. Insbesondere dann, wenn die nicht zu aktivierenden Flächen durch Photoresist geschützt werden, können photolitographisch beliebige Muster aufgebracht werden, welche nach der Oberflächenaktivierung durch Plasmaätzen oder Coronaentladung leicht gestrippt werden können. Die auf diese Weise vorbehandelte Folie bzw. der Folienverbund kann in konventioneller Weise nach der Multilayertechnologie weiter verarbeitet werden. Innerhalb der starren Bereiche kann in bekannter Weise durch Ritzen, Fräsen od. dgl. eine Perforation ausgebildet werden, welche das spätere Trennen der starren und flexiblen Bereiche erleichtert. Herkömmliche, glasgewebeverstärkte Epoxidharze im B-Zustand, sogenannte Prepregs, können mit einem derartig modifizierten Folienmaterial als Klebeschicht Verwendung finden, wobei im Gegensatz zu den bekannten Verfahrensweisen auch bei der Verwendung von Prepregs eine Klebeschicht zum Einsatz gelangen kann, welche nicht konfektioniert werden muß. Es ist lediglich vorteilhaft, derartige Prepregs mit hohem Harzanteil und geringem Fließvermögen einzusetzen, da mit sinkendem Glasanteil auch die spezifische Festigkeit der Klebeschicht abnimmt und somit das Ausbrechen der nicht benötigten Bereiche erleichtert wird. Da an den Stellen, an welchen die Oberflächenbehandlung bzw. -aktivierung nicht erfolgte, eine dauerhafte Klebung nicht eintritt, entsprechen die Bruchflächen exakt den Trennlinien zwischen behandelten und nicht behandelten Folienoberflächen.

Wesentlich für die Erfindung ist die Tatsache, daß polymere Materalien für die flexiblen Träger Verwendung finden, welche folgende Eigenschaften haben:

(a) hohe thermische Beständigkeit Glaserweichungspunkt vorzugsweise über 100° C

(b) hohe Chemikalienbeständigkeit gegenüber Säruen und Laugen

(c) hohe mechanische Festigkeit und Dimensionsstabilität

(d) Haftfestigkeit der mit dem flexiblen Träger verbundenen Leiterbahnen, beispielsweise einer Kupferfolie, über 600N/m (gemessen nach IPC CF 150)

(e) sehr niedrige Oberflächenspannung von weniger als 40mN/m.

Dabei haben sich Polyetherketone, insbesondere Polyetheretherketon als die am besten geeigneten Polymere herausgestellt.

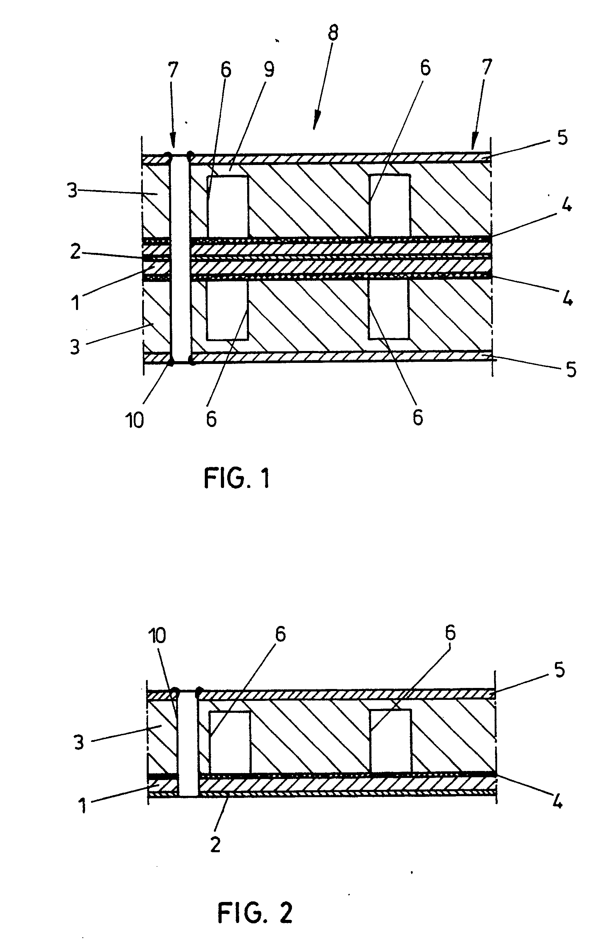

Die Erfindung wird nachfolgend an Hand von Ausführungsbeispielen näher erläutert. In dieser zeigen Fig.1 eine erste Ausführungsform einer erfindungsgemäßen Mulitlayerleiterplatte, wobei der flexible Träger zwischen zwei starren Leiterplatten liegt; und Fig.2 eine abgewandelte Ausführungsform einer erfindungsgemäßen Multilayerleiterplatte, wobei der flexible Träger lediglich auf einer Seite mit einer starren Platte verbunden ist.

In Fig.1 ist mit 1 ein von einer Polyetherketon (PEK)-Folie, insbesondere von einer Polyetheretherketon (PEEK)-Folie gebildeter Träger 1 dargestellt, in welchem Leiterbahnen 2 aus Kupfer integriert sind. Für eine nachfolgende Verbindung des flexiblen Trägers 1 mit den starren Platten 3 wird der flexible Träger an seiner, zu den starren Platten gewandten Oberfläche in denjenigen Bereichen, in welchen eine Verbindung mit den starren Platten 3 erfolgen soll, durch Plasmaätzen oder eine Coronaentladung oder auch durch ein Beflammen bzw. durch chemische Verfahren modifiziert, um die im unbehandeltem Zustand der PEK- bzw. der PEEK-Folie niedrige Oberflächenspannung auf einen Wert von über 50mN/m, vorzugsweise über 70mN/m anzuheben, wobei die Oberflächenbehandlung des flexiblen Trägers in den weiter unten angeführten Beispielen noch näher beschrieben werden wird.

Zur Verbindung des flexiblen Trägers 1 mit den starren Platten 3 werden herkömmliche, glasgewebeverstärkte Epoxidharze im B-Zustand, sogenannte Prepregs 4, zwischen flexiblem Träger 1 und starrer Leiterplatte 3 angeordnet und gemäß bekannten Verfahren der Multilayertechnologie zu einem mehrlagigen Aufbau verpreßt. Auf der Außenfläche der starren Leiterplatten ist weiters eine Kupferschicht 5 vorgesehen, welche nach dem Verpressen auf bekannte Art und Weise strukturiert wird, worauf nach der Strukturierung der Leiterbahnen auf den Leiterplatten 3 diejenigen Bereiche der starren Leiterplatte 3 entfernt werden, in welchen eine gewünschte Flexibilität erzielt werden soll. Zu diesem Zweck ist die Leiterplatte 3 mit Nuten bzw. Ausnehmungen 6 versehen, entlang welcher eine einfache Trennung der gewünschten Bereiche erfolgen kann. Da die Oberfläche des flexiblen Trägers 1 nur in denjenigen Bereichen entsprechend modifiziert wurde, in welchen eine Verbindung mit den starren Leiterplatten 3 erfolgen soll, wobei diese Bereiche in Fig.1 mit 7 bezeichnet sind, kann in dem Bereich 8 unter sauberer Kantenausbildung auch die Prepreg-Folie 4 ohne weiteres entfernt werden, da aufgrund der geringen Oberflächenspannung keine Verbindung derselben mit dem flexiblen Träger erfolgte. Die Heraustrennung der zu entfernenden Bereiche 8 der starren Leiterplatten 3 kann dabei durch einfaches Brechen, Fräsen oder durch die Verwendung von einfachen Stanzwerkzeugen ermöglicht werden, wobei die Stanzwerkzeuge lediglich den geringen verbleibenden Bereich 9 der Leiterplatten im Bereich der Bohrungen bzw. Ausnehmungen 6 durchtrennen müssen.

Bei der in Fig.2 dargestellten Ausführungsform ist eine starre Leiterplatte 3 nur auf einer Seite des flexiblen Trägers 1, welcher wiederum Leiterbahnen 2 aufweist vorgesehen, sodaß in diesem Fall die Behandlung der Oberfläche des wiederum von einer PEK-, insbesondere einer PEEK-Folie gebildeten Trägers 1 nur an der von den Leiterbahnen abgewandten Oberfläche vorgenommen wird. Die Abdeckung der Bereiche der Oberfläche des flexiblen Trägers 1, welche nicht modifiziert werden sollen, kann beispielsweise durch ein Beschichten mit einem Photoresist, wie dies im nachfolgenden noch näher erläutert werden wird, oder auch durch Masken oder Folien erfolgen, welche nach der Oberflächenbehandlung in einfacher Weise wiederum entfernt werden können. Durch die äußerst geringe Oberflächenspannung der unbehandelten PEK-, insbesondere PEEK-Folie 1 können unbearbeitete, d.h. vollflächige Klebefolien bzw. Prepregs 4 verwendet werden, da in denjenigen Bereichen, in welchen eine Oberflächenbehandlung des flexiblen Trägers 1 nicht durchgeführt wurde, keine Verbindung mit den Prepregs 4 erfolgt, so daß diese ebenso wie die starren Leiterplattenteile entfernt werden können, um derart die flexiblen Bereiche freizulegen.

Für die Herstellung von Verbindungen zwischen den an der Oberfläche der starren Leiterplatten 3 vorgesehenen Leiterbahnen 5 und den Leiterbahnen 2 der flexiblen Folie 1 können auf bekannte Art und Weise Bohrungen für ein nachfolgendes Bonden bzw. Verlöten angebracht werden, wobei derartige Bohrungen mit 10 angedeutet sind.

Im nachfolgenden werden einige Ausführungsbeispiele zur Herstellung einer erfindungsgemäßen Multilayerleiterplatte näher beschrieben.

Beispiel 1:

Ein zweilagiger Verbund entsprechend Fig.1 aus einer Polyetheretherketon-Folie 1 mit innenliegenden 35μm dicken Kupferleitbahnen 2 und einer Gesamtdicke von 200μm wird mit einem UV-Lichthärtenden Photoresist beschichtet, 70 Sekunden belichtet und anschließend mit organischen Lösungsmitteln entwickelt. Dieser Aufbau wird 15 Minuten bei 150°C in einer Niederdruck-Plasma-Anlage behandelt. Die Schutzschicht aus Photoresist wird nachfolgend mit einem Lösungsmittel, wie z.B. Dimethylchlorid, von der PEEK-Folie 1 abgelöst. Die oberflächenbehandelte Kunststoff-Folie 1 konnte mit einem Prepreg 4 der Type 2116 (Dicke 115μm) mit vorbereiteten, strukturierten, starren Laminaten bzw. Leiterplatten 3 mit einer Dicke von 740μm zu einem mehrlagigen Aufbau verpreßt werden. Es konnten die für FR 4 Materialien, welche Standardmaterialien zur Herstellung von Leiterplatten darstellen, üblichen Preßparameter gewählt werden. Die Gesamtstabilität des Verbundes ist ausreichend groß, so daß die nachfolgenden Bearbeitungsprozesse, wie Bohren, Verkupfern, Strukturieren, Siebdruck, Konturbearbeitung ohne Probleme erfolgen können.

Beispiel 2:

Eine einseitig mit Kupferleitbahnen 2 versehene PEEK-Folie 1, entsprechend der in Fig.2 dargestellten Ausführungsform, wird auf der kupferfreien Seite mit einem Plasma behandelt. Die später flexiblen Bereiche sind durch einen in UV-Licht härtenden Film geschützt, der mit einem alkalischen Medium entwickelt wurde. Nach der Plasmabehandlung ist der Photoresist problemlos mit Natronlauge strippbar.

Die so vorbereitete PEEK-Folie 1 wird mittels Epoxidharz-Prepreg 4 der Type 1080 (60μm dick) auf die Unterseite einer starren, 740μm dicken Leiterplatte 3 nach Multilayertechnologie aufgepreßt, d.h. 60 Minuten bei 180°C und einem spezifischen Druck von 25kg/cm². Bohren, Verkupfern, Strukturieren und die abschließende Konturbearbeitung können mit den üblichen Maschineneinstellungen erfolgen.

Beispiel 3:

Ein Verbund aus PEEK-Folien 1 wie in Beispiel 1 wird zu 2/3 der Fläche einer Plasmabehandlung unter den folgenden Bedingungen unterzogen:
Behandlungsdauer: 15 Minuten
Behandlungstemperatur: 120°C
Gaszusammenstellung: 15 % CF$_4$
85 % O$_2$
Vakuum: 300mbar

Der Folienverbund wird mit einem 1080-Prepreg 4 auf eine 226μm dicke und strukturierte Leiterplatte 3 mit für FR 4-Materialien üblichen Preßparametern verklebt. Die Haft festigkeit, gemessen mit dem Trommelschälversuch, zwischen ler PEEK-Folie 1 und dem FR 4-Verbund 3 erreichte die Materialfestigkeit der thermoplastischen Folie.

Beispiel 4:

Eine strukturierte PEEK-Folie 1 wie in Beispiel 2 wird partiell 10 Minuten bei 120°C einem Plasma ausgesetzt. Das ionisierte Gas erhöhte die Oberflächenspannung (Wasserbenetzbarkeit) von 35mN/m an den unbehandelten Stellen der Folie 1 auf 73mN/m an den behandelten Bereichen.

Die Haftfestigkeit bei Verwendung eines 2116-Prepregs 4 als Kleber erreichte im Trommelschälversuch die Materialfestigkeit der PEEK-Folie 1.

**Ansprüche**

1. Multilayerleiterplatte mit flexiblen Bereichen (8), bei welcher starre Plattenbereiche (3) mit einem flexiblen Träger (1) verbunden sind, dadurch gekennzeichnet, daß als flexibler Träger (1) eine Polyetherketon-, insbesondere Polyetheretherketon-Folie verwendet wird und daß die starren Plattenbereiche (3) mit der Folie (1) verklebt sind.

2. Verfahren zur Herstellung einer Multilayerleiterplatte nach Anspruch 1, dadurch gekennzeichnet, daß die Polyetherketon- bzw. Polyetheretherketon-Folie (1) in denjenigen Bereichen (7), welche in der Folge mit den starren Plattenbereichen (3) dauerhaft verbunden werden sollen, zur Erhöhung ihrer Oberflächenspannung oberflächlich durch chemisches Ätzen, Beflammen, Coronaentladung oder Plasmaätzen modifiziert wird und in der Folge mit dem starren Leiterplattenmaterial (3), insbesondere unter Zwischenschaltung eines Prepregs (4), verklebt wird.

3. Verfahren nach Anspruch 2, dadurch gekennzeichnet, daß der flexible Träger (1) mit integrierten und/oder auf einer Fläche strukturierten Leiterbahnen (2,5) eingesetzt wird, wobei die von Leiterbahnen (2,5) freie Seite zur Erhöhung der Oberflächenspannung modifiziert wird.

4. Verfahren nach einem der Ansprüche 2 oder 3, dadurch gekennzeichnet, daß die zu modifizierende Fläche der Polyetherketon-, insbesondere der Polyetheretherketon-Folie (1), vor der Oberflächenbehandlung mit einem Photoresist beschichtet und zur Freilegung der zu modifizierenden Oberflächenbereiche photolitographisch strukturiert wird.

5. Verfahren nach einem der Ansprüche 1 bis 4, dadurch gekennzeichnet, daß die Oberfläche der mit den starren Plattenbereichen (3) zu verbindenden Teilbereiche des flexiblen Trägers (1) zur Ausbildung einer Oberflächenspannung von größer als 50mN/m, vorzugsweise größer als 70mN/m, modifiziert werden.

6. Verfahren nach einem der Ansprüche 1 bis 5, dadurch gekennzeichnet, daß als flexibler Träger (1) für die starren Plattenteile (3) ein mindestens zweilagiger Verbund aus Polyetherketon-Folien (1) mit innenliegenden Leiterbahnen (2) eingesetzt wird.

FIG. 1

FIG. 2